Europäisches Patentamt

European Patent Office

Office européen des brevets

(11) Publication number: **0 448 869 A1**

# EUROPEAN PATENT APPLICATION

(21) Application number: 90313004.5

(51) Int. Cl.5: **H01L 31/0236**

(22) Date of filing: 29.11.90

(30) Priority: 29.12.89 US 459169

(43) Date of publication of application:
02.10.91 Bulletin 91/40

(84) Designated Contracting States:
DE FR GB IT NL

(71) Applicant: AMERICAN TELEPHONE AND
TELEGRAPH COMPANY
550 Madison Avenue
New York, NY 10022(US)

(72) Inventor: Chi, Gou-Chung
125 Sulfrian Road
New Providence, New Jersey 07974(US)

Inventor: Hollenhorst, James Nolan
15 Walker Drive
New Providence, New Jersey 07974(US)
Inventor: Morgan, Robert Anthony
20 East Smith Street
Topton, Pennsylvania 19562(US)
Inventor: Muehlner, Dirk Joachim
120 Roland Road
Murray Hill, New Jersey 07974(US)

(74) Representative: Watts, Christopher Malcolm
Kelway et al
AT&T (UK) LTD. AT&T Intellectual Property
Division 5 Mornington Road
Woodford Green Essex IG8 OTU(GB)

(54) Optical device including a grating structure.

(57) Substrate-supported optical device structures such as, e.g., quantum-well infrared detectors/detector arrays are provided with a diffraction grating (14) for optical coupling. Preferred gratings (14) are formed in a nonepitaxial layer which, preferably, consists of a material which is different from underlying semiconductor material (12). Conveniently, a grating pattern is formed by etching, with the underlying material serving as an etch stop. For example, on a GaAs-AlGaAs device, polycrystalline silicon can be deposited and etched in this fashion.

## FIG. 1

## OPTICAL DEVICE INCLUDING A GRATING

### Technical Field

The invention is concerned with substrate-supported optical devices comprising a grating.

### Background of the Invention

For the detection or modulation of optical radiation, especially at infrared frequencies, devices have been proposed based on intersubband or bound-to-continuum excitation of carriers in quantum wells as disclosed, respectively, in

B. F. Levine et al., "Strong 8.2 $\mu$m Infrared Intersubband Absorption in Doped GaAs/AlAs", Applied Physics Letters, Vol. 50(1987), pp. 273-275; and

B. F. Levine et al., "High-detectivity D* = 1.0 x $10^{10}$ cm $Hz^{-1/2}$/W GaAs/AlGaAs Multiquantum Well $\lambda$ = 8.3 $\mu$m Infrared Detector", Applied Physics Letters, Vol. 53(1988), pp. 296-298.

Such devices include a substrate-supported layered structure forming quantum wells between barriers, and they can be conveniently implemented, e.g., by means of doped gallium arsenide well layers and aluminum-gallium arsenide barrier layers on a gallium-arsenide substrate. (By suitable choice of layer thickness and layer composition, devices can be made to have peak absorption at any desired wavelength in the "atmospheric window" region from 8 to 14 micrometers.) Resulting structures are considered suitable for use in, e.g., focal-plane arrays, high-speed detectors, optical heterodyne receivers, and vertically integrated long-wavelength infrared spectrometers.

Since, characteristically, responsivity of quantum-well detectors is dependent on the direction of incidence of radiation, with essentially zero response for incidence perpendicular to the layered structure, grating couplers have been proposed for oblique coupling of radiation. Relevant in this respect are the papers by

K. W. Goossen et al., "Grating Enhanced Quantum Well Detector", Applied Physics Letters, Vol. 47-(1985), pp. 1257-1259; and

K. W. Goossen et al., "Grating Enhancement of Quantum Well Detector Response", Applied Physics Letters, Vol. 53(1988), pp. 1027-1029.

In the interest of ease of manufacture of devices of interest, and further in the interest of providing for a structure which is readily adaptable to device arrays, the invention as described below provides for a preferred grating arrangement, with preferred aspects, such as etch stops or faster fabrication times or both.

### Summary of the Invention

Substrate-supported optical device structures comprising an epitaxially formed layer are provided with a grating for optical coupling. Preferred gratings comprise non-epitaxially formed material.

Especially when a grating is made by etching a grating pattern into a layer, preferred grating layer material is different from the underlying material, so that, conveniently, the underlying material may act as an etch stop. For example, on a GaAs-AlGaAs device, polycrystalline silicon can be formed and etched in this fashion.

### Brief Description of the Drawing

FIG. 1 is a schematic elevational view of a device comprising a plurality of optical detectors, equipped with gratings in accordance with a preferred embodiment of the invention; and

FIG. 2 is a diagram representing experimentally determined relationships between wavelength and radiation flux responsivity for a preferred device in accordance with the invention as compared with a prior-art device.

### Detailed Description

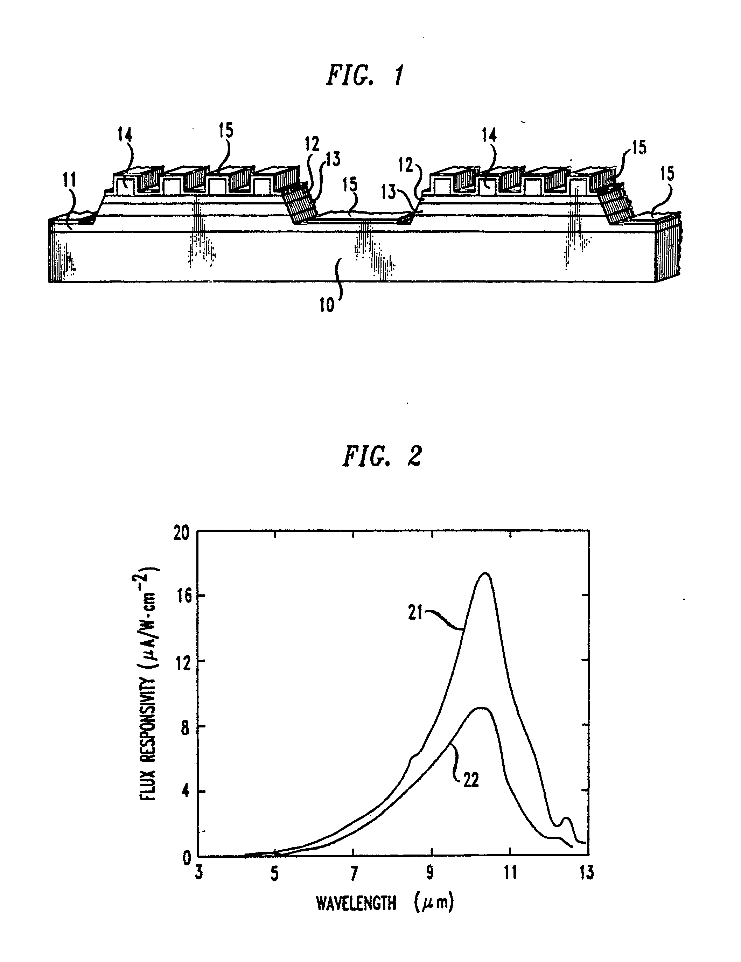

FIG. 1 shows a device structure comprising substrate 10 (consisting of semi-insulating gallium arsenide, for example), first and second contact layers 11 and 12 (consisting of heavily n-doped gallium arsenide, for example), layered structure 13 forming at least one quantum well (comprising gallium arsenide well layers and aluminum-gallium arsenide barrier layers, for example), grating structure 14 (consisting essentially of polycrystalline silicon, for example), and contacts 15 (consisting of germanium-gold alloy, for example).

FIG. 2 shows curves 21 and 22, curve 21 corresponding to a preferred embodiment of the invention including a grating, and curve 22 corresponding to a prior-art device illuminated obliquely via a 45-degree beveled face in the substrate. The curves represent flux responsivity as a function of wavelength, determined with an 500 C blackbody radiation source, at a detector temperature of 77 K. Superior responsivity of a device including a grating is readily apparent upon comparison of curve 21 with curve 22.

Other than gallium arsenide, indium phosphide or other Group III-V materials can be used as device materials; and use of Group II-VI and Group IV materials is not precluded. For example, with respect to the latter, devices may be of a type as disclosed in U.S. patent 4,661,829, issued April 28,1987 to J. C. Bean et al., involving strained epitaxial germanium-silicon layers. More specifically contemplated in this respect is the use of an etched polycrystalline silicon layer as a grating on germanium. On Group III-V materials, Group IV gratings are preferred.

Grating design involves choice of material, grating layer thickness, and grating period. Preferred grating layer thickness is inversely related to the refractive index of the grating material, in accordance with the idealized relationship

$$n\,h = \lambda/4,$$

where $\lambda$ denotes a wavelength of interest, $n$ denotes the refractive index of the grating layer material, and $h$ denotes grating layer thickness. For example, with $\lambda$ = 10 micrometers, and n = 3.4 (as for silicon), preferred grating layer thickness $h$ is approximately 0.75 micrometer. In the interest of minimized grating layer thickness, high-index materials are preferred as grating materials. The efficacy of a grating may be enhanced also by suitable choice of an overlying material as, e.g., a contact metallization material.

Preferred period of the grating depends on the direction of radiation incidence and may be motivated by the desire for a first-order diffracted beam to propagate in a direction parallel to the layered structure. For example, in the case of perpendicular incidence, a preferred grating period is approximately $d = \lambda/n$.

As illustrated by FIG. 1, a grating may have rectangular profile and may be disposed on a deposited device structure. Among alternatives within the scope of the invention are triangular profiles, and application of a grating to the substrate. Also, gratings may be present on the device structure as well as on the substrate. Preferred gratings can readily serve, e.g., to couple radiation into (2-dimensional) focal-plane detector arrays.

Depending on specific choice of materials, the following are among benefits as may be realized by preferred embodiments of the invention:

    (i) rapid, nonepitaxial deposition of preferred grating layer material,
    (ii) high refractive index, and thermal matching of preferred grating layer material, and
    (iii) reliance on material underlying a grating layer material to serve as an an etch stop.

A device whose performance is illustrated in FIG. 2, curve 21 was made according to the following Example. Numerical values are nominal or approximate.

Example

On a semi-insulating gallium arsenide substrate, a 1-micrometer first contact layer of gallium arsenide was deposited (doped n = 2 x $10^{18}$ cm$^{-3}$), followed by a detector structure consisting of 50 periods of 4-nanometer gallium arsenide quantum-well layers (doped n = 2 x $10^{18}$ cm$^{-3}$) between 30-nanometer $Al_{0.26}Ga_{0.74}As$ undoped barrier layers (resulting in a barrier height of approximately 250 meV). A second contact layer of 0.5 micrometer gallium arsenide was deposited, doped n = 2 x $10^{18}$ cm$^{-3}$. Layers as described above were deposited by molecular-beam epitaxy.

On the second contact layer a 750-nanometer layer of polysilicon was deposited by e-beam evaporation. A 4-micrometer-period grating was formed in the polysilicon layer by reactive-ion etching, with a photoresist layer as etch mask. The etching gas was approximately 95 percent $CF_4$ and 5 percent oxygen by volume. The second contact layer (underlying the polysilicon layer) was used as an etch stop. Scanning-electron-microscopic inspection showed that the grating had an essentially square profile, with a 1.9-micrometer/2.1-micrometer duty cycle.

After formation of the grating as described, a mesa structure having an approximate diameter of 250 micrometers was chemically etched in the presence of a photoresist mask. Metallic contact layers were deposited by sequential e-beam evaporation of germanium-gold (20 nanometers), silver (50 nanometers), and gold (75 nanometers) in the presence of a lift-off mask.

## Claims

1. A device comprising an epitaxial semiconductor layer (11,13, 12) located on a substrate (10),
   said device comprising optical diffraction grating means (14) for coupling optical radiation, said diffraction grating means being located on said substrate or on said epitaxial layer,
   CHARACTERIZED IN THAT the material of said diffraction grating means (14) is formed nonepitaxially.

2. The device of claim 1 in which said diffraction grating means is located on said substrate.

3. The device of claim 1 in which said diffraction grating means is located on said epitaxial layer.

4. The device of claim 1, in which said optical diffraction grating means is located on said substrate as well as on said epitaxial layer.

5. The device of claim 1 in which said diffraction grating means is located on an electrical contact layer.

6. The device of claim 1 in which the material of said diffraction grating means is different from the underlying material.

7. The device of claim 6 in which said semiconductor layer comprises a Group III-V material and in which the material of said diffraction grating means comprises a Group-IV element.

8. The device of claim 7 in which said Group-IV element is silicon.

9. The device of claim 7 in which said semiconductor layer comprises gallium arsenide.

10. The device of claim 1 in which said semiconductor layer comprises a Group IV material.

## FIG. 1

## FIG. 2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | GB-A-2 071 414 (ELEKTRONIKCENTRALEN) <br> * page 3, lines 82 - 96; figure 7 * | 1,3,6 | H 01 L 31/0236 |
| A | APPLIED PHYSICS LETTERS. vol. 54, no. 25, 19 June 1989, NEW YORK US pages 2515 - 2517; G.HASNAIN ET AL.: "GaAs/AlGaAs MULTIQUANTUM WELL INFRARED DETECTOR ARRAYS USING ETCHED GRATINGS" <br> * the whole document * | 1,3,5,9 | |
| A | PATENT ABSTRACTS OF JAPAN vol. 13, no. 374 (E-808)(3722) 18 September 1989, <br> & JP-A-01 125988 (HITACHI LTD) 18 May 1989, <br> * the whole document * | 1,2 | |
| A | EP-A-0 127 317 (EXXON RESEARCH AND ENGINEERING COMPANY) <br> * the whole document * | 1 | |
| A,D | APPLIED PHYSICS LETTERS. vol. 53, 19 September 1988, NEW YORK US pages 1027 - 1029; K.W.GOOSSEN ET AL.: "GRATING ENHANCEMENT OF QUANTUM WELL DETECTOR RESPONSE" <br> * the whole document * | 1 | TECHNICAL FIELDS SEARCHED (Int. Cl.5) <br><br> H 01 L |
| A,D | APPLIED PHYSICS LETTERS. vol. 47, no. 12, 15 December 1985, NEW YORK US pages 1257 - 1259; K.W.GOOSSEN ET AL.: "GRATING ENHANCED QUANTUM WELL DETECTOR" <br> * the whole document * | 1 | |

The present search report has been drawn up for all claims

| Place of search | Date of completion of search | Examiner |
|---|---|---|
| The Hague | 22 April 91 | LINA F. |